# EUROPÄISCHE PATENTANMELDUNG

(11) **EP 0 996 163 A2**
(43) Veröffentlichungstag der Anmeldung: **26.04.2000**
(21) Anmeldenummer: 99120075.9
(22) Anmeldetag: 20.10.1999
(51) Int. Cl.: H01L 27/115, H01L 21/8247

(54) **Speicherzellenanordnung und Implantationsmaske zum Herstellen von dieser**

(30) Priorität: 23.10.1998 DE 19848999
(71) Anmelder: Infineon Technologies AG, 81541 München (DE)
(72) Erfinder: Hönigschmid, Heinz, 82319 Starnberg (DE); Braun, Georg, 80339 München (DE)
(74) Vertreter: Zedlitz, Peter

(57) **Zusammenfassung**

Die Erfindung betrifft eine Speicherzellenanordnung aus Hybridenspeicherzellen, bei der einzelne Bitleitungspaare (BL0, bBL0; BL1, bBL1) durch jeweils eine Bitleitung eines anderen Bitleitungspaares getrennt sind, so daß die Speicherzellen zueinander unter 1/4-Teilung angeordnet sind. Dadurch können in sich zusammenhängende Implantationsmasken-Teile (12) ohne Verbindungs- bzw. Eckbereiche verwendet werden, was Implantationsprobleme vermeidet und dennoch die Herstellung von Transistoren unterschiedlicher Einsatzspannung erlaubt.

## Beschreibung

Die vorliegende Erfindung betrifft eine Speicherzellenanordnung aus mit Wortleitungen und Bitleitungspaaren in einer Matrix verbundenen hybriden Speicherzellen, die jeweils aus einem Speicherkondensator und einem Auswahltransistor bestehen, wobei jeder Speicherzelle ein Kurzschlußtransistor mit einer von der Einsatzspannung des Auswahltransistors unterschiedlichen Einsatzspannung zugeordnet ist. Außerdem betrifft die vorliegende Erfindung eine Implantationsmaske zum Herstellen einer solchen Speicherzellenanordnung.

In herkömmlichen Speicherzellenanordnungen, beispielsweise solchen mit Auswahltransistoren und ferroelektrischen Speicherzellen, werden im allgemeinen nur Transistoren gleicher Art im Speicherzellenfeld verwendet. Transistoren "gleicher Art" bedeutet dabei insbesondere, daß diese Transistoren vom gleichen Leitungstyp sind und auch jeweils dieselbe Einsatzspannung haben. Die Verwendung von solchen Transistoren gleicher Art hat den nicht unerheblichen Vorteil, daß die zur Einstellung der Einsatzspannung notwendige Implantation großflächig vorgenommen werden kann und die Herstellung der Implantationsmaske somit vollkommen unkritisch ist.

Als Beispiel seien gegenwärtige DRAMs (dynamische Schreib/-Lesespeicher) genannt, welche aus n-Kanal-MOS-Transistoren gleicher Art im Zellenfeld aufgebaut sind, das über Wortleitungen und Bitleitungspaare aus nebeneinander angeordneten Bitleitungen BL und bBL besteht.

Es ist bekannt, daß bei Speicherzellenanordnungen der eingangs genannten Art Probleme infolge von Störimpulsen, die letztlich zu Informationsverlusten führen, auftreten können (vgl. DE 198 32 994 A1 bzw. GR 98 P 2134 DE). Zur Vermeidung solcher Informationsverluste wurde bereits daran gedacht, jedem Speicherkondensator noch einen Kurzschlußtransistor zuzuordnen, der zu bestimmten Zeiten die Elektroden des Speicherkondensators kurzschließt. Dieser zusätzliche Kurzschlußtransistor sollte aber in bevorzugter Weise eine von der Einsatzspannung des Auswahltransistors verschiedene Einsatzspannung haben. In dem obigen Beispiel eines DRAMs mit n-Kanal-MOS-Feldeffekttransistoren für die Auswahltransistoren können so in vorteilhafter Weise für die Kurzschlußtransistoren Feldeffekttransistoren vom Verarmungstyp eingesetzt werden.

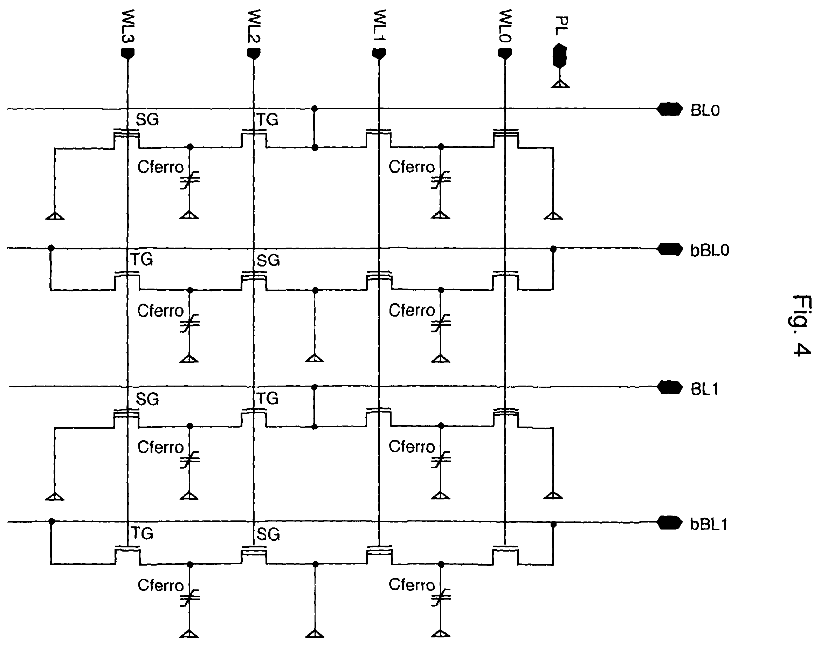

Fig. 4 zeigt eine herkömmliche Speicherzellenanordnung mit Wortleitungen WL0, WL1, WL2, WL3 und Bitleitungen BL0, bBL0, BL1 und bBL1, Auswahltransistoren TG, ferroelektrischen Speicherkondensatoren Cferro und Kurzschlußtransistoren SG. Die Speicherzellen sind dabei so miteinander verbunden, daß an der als Wortleitung und als Steuerleitung dienenden Leitung sowohl Auswahltransistoren TG als auch Kurzschlußtransistoren SG angeschlossen sind. Die Auswahltransistoren TG und die Kurzschlußtransistoren SG sind dabei abwechselnd mit dieser Leitung verbunden.

Die Funktionsweise einer solchen Speicherzellenanordnung wird im folgenden unter der Annahme erläutert, daß die Auswahltransistoren n-Kanal-MOS-Feldeffekttransistoren vom Anreicherungstyp sind, daß weiterhin die Kurzschlußtransistoren n-Kanal-MOS-Feldeffekttransistoren vom Verarmungstyp sind, und daß die Einsatzspannung der Kurzschlußtransistoren, die von der Einsatzspannung der Auswahltransistoren abweicht, negativer als der negative Wert der Spannung an einer gemeinsamen Elektrode PL ist.

Wird die Speicherzellenanordnung von Fig. 4 eingeschaltet, so befinden sich alle Wortleitungen WL auf 0 V. Zuerst wird sodann die gemeinsame Elektrode PL von 0 V auf die Spannung VDD/2 (VDD = Versorgungsspannung) hochgefahren. Da nun die Einsatzspannung der Feldeffekttransistoren vom Verarmungstyp entsprechend stark negativ gewählt ist, leiten diese Feldeffekttransistoren auch dann noch, nachdem die gemeinsame Elektrode PL auf VDD/2 aufgeladen wurde. Damit sind alle Elektroden der ferroelektrischen Speicherkondensatoren Cferro kurzgeschlossen.

Um nun auf bestimmte Speicherzellen zugreifen zu können, wird die entsprechende Wortleitung, also beispielsweise die Wortleitung WL2 von 0 V auf die volle Versorgungsspannung VDD oder höher aufgeladen, wodurch die gewünschten ferroelektrischen Kondensatoren Cferro mit den entsprechenden Bitleitungen BL verbunden werden. Befinden sich diese Bitleitungen auf einem Potential, das größer oder kleiner als das Potential der gemeinsamen Elektrode PL ist, vollzieht sich ein Ladungsausgleich zwischen den selektierten ferroelektrischen Kondensatoren Cferro und den zugehörigen Bitleitungen BL. Bevor dies aber eintritt, müssen jedoch die Kurzschlußtransistoren SG, die die selektierten ferroelektrischen Kondensatoren Cferro kurzschließen, abgeschaltet werden. Dies geschieht durch ein negatives Potential an der entsprechenden Wortleitung, also beispielsweise an der Wortleitung WL3. Durch dieses negative Potential werden lediglich die gewünschten Feldeffekttransistoren vom Verarmungstyp abgeschaltet.

Die Feldeffekttransistoren vom Anreicherungstyp, also die Auswahltransistoren, die ebenfalls mit der Wortleitung WL3 verbunden sind, waren bereits durch das Bereitschaftspotential von 0 V abgeschaltet und werden durch das negative Potential nur noch hochohmiger gemacht.

Nach Bewerten des Lesesignales und dessen Verstärken wird schließlich die selektierte Wortleitung, also beispielsweise die Wortleitung WL2, wieder auf 0 V entladen, was die selektierten Speicherzellen wieder von den Bitleitungen abtrennt. Um den Kurzschluß der Elektroden mit den selektierten Speicherzellen wiederherzustellen, wird die Wortleitung, die mit dem entsprechenden Feldeffekttransistor vom Verarmungstyp verbunden ist, also im vorliegenden Beispiel die Wortleitung WL3, wieder auf 0 V zurückgebracht.

Bei der in Fig. 4 gezeigten Speicherzellenanordnung besteht, wie bereits oben angedeutet wurde, ein Bitleitungspaar aus zwei Bitleitungen BL0 und bBL0, die nebeneinander angeordnet sind und so für eine Speicherzelle eine 1/2-Teilung bewirken.

Die Herstellung der Speicherzellenanordnung von Fig. 4 erfordert es, daß die Kurzschlußtransistoren SG mit einer anderen Einsatzspannung als die Auswahltransistoren TG versehen werden. Hierzu ist eine zusätzliche Implantationsmaske notwendig, damit beispielsweise die Eigenschaften der Kurzschlußtransistoren, bei denen es sich im obigen Beispiel um n-Kanal-MOS-Feldeffekttransistoren vom Verarmungstyp handelt, entsprechend eingestellt werden können.

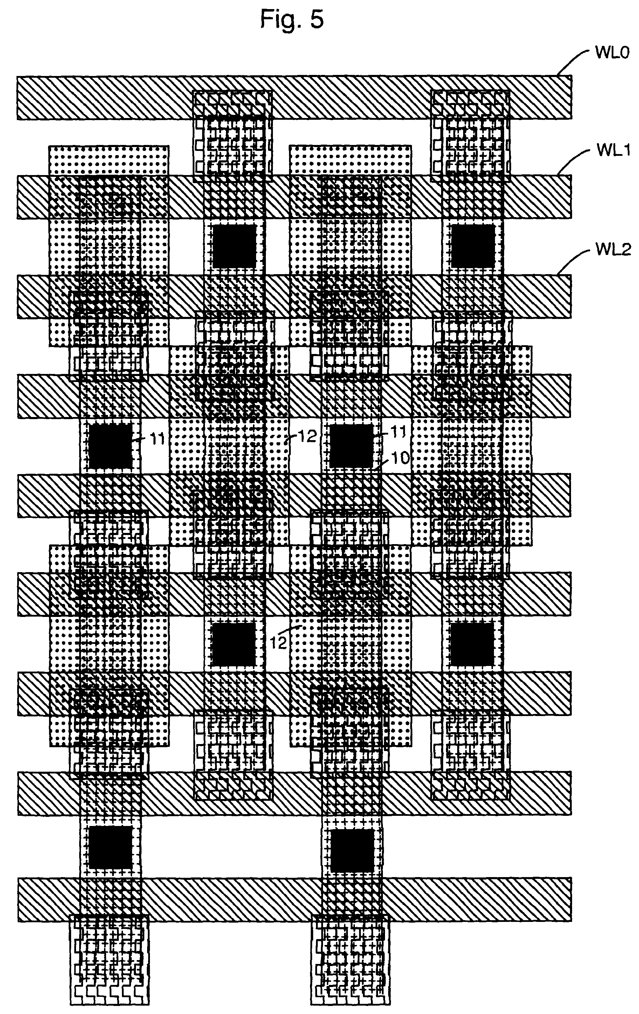

Die Fig. 5 zeigt ein hierzu geeignetes Layout mit Wortleitungen WL0, WL1, WL2, ..., aktiven Bereichen 10 unterhalb der (nicht dargestellten) Bitleitungen, Bitleitungskontakten 11 und einer Implantationsmaske 12, die so gestaltet ist, daß in der Richtung der Bitleitungen auf jeweils zwei Kurzschlußtransistoren (etwa unterhalb der Implantationsmaske 12) zwei Auswahltransistoren folgen, wie dies auch aus der Fig. 4 zu ersehen ist.

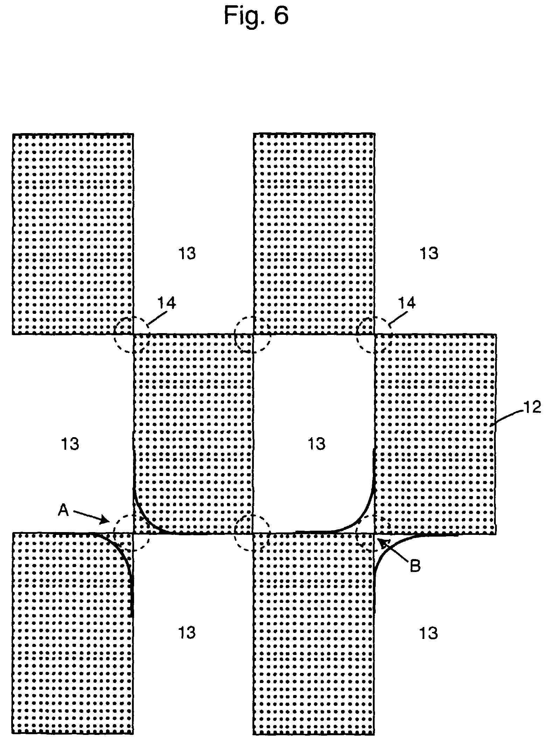

In Fig. 6 ist die Implantationsmaske 12 nochmals gesondert herausgestellt, wobei diese Implantationsmaske 12 so zu verstehen ist, daß die nicht-punktierten Teile aus einer Chromschicht 13 bestehen. In den Eck- bzw. Verbindungspunkten dieser Chromschicht 13 treten bei einer Implantation Maskenprobleme auf, wie dies durch strichlierte Kreise 14 angedeutet ist:

Bei der Maskenherstellung können nämlich keine punktförmigen Auflösungen realisiert werden, so daß es zu verstärkten Eckrundungen kommt, die entweder nicht implantieren (vgl. Pfeil A) oder die ein nicht gewolltes Implantieren hervorrufen (vgl. Pfeil B).

Infolge der oben aufgezeigten Probleme ist es daher in der Praxis bisher nicht möglich, eine Speicherzellenanordnung mit Kurzschlußtransistoren und Auswahltransistoren unterschiedlicher Einsatzspannung in befriedigender Weise zu schaffen.

Es ist daher Aufgabe der vorliegenden Erfindung, eine Speicherzellenanordnung zu schaffen, bei der Auswahltransistoren und Kurzschlußtransistoren ohne weiteres mit unterschiedlichen Einsatzspannungen versehen werden können; außerdem soll eine Implantationsmaske angegeben werden, die zur Herstellung einer solchen Speicherzellenanordnung geeignet ist.

Diese Aufgabe wird bei einer Speicherzellenanordnung der eingangs genannten Art erfindungsgemäß dadurch gelöst, daß die einzelnen Bitleitungspaare durch jeweils eine Bitleitung eines anderen Bitleitungspaares getrennt sind, so daß die Speicherzellen zueinander unter 1/4-Teilung angeordnet sind.

Eine Implantationsmaske zum Herstellen einer solchen Speicherzellenanordnung zeichnet sich dadurch aus, daß einzelne Implantationsmasken-Teile derart stufenförmig versetzt über nebeneinanderliegende Bitleitungen gelegt sind, daß jeder einzelne Implantationsmasken-Teil in sich zusammenhängend ist, und daß die einzelnen Implantationsmasken-Teile parallel zueinander und im Abstand voneinander schräg zu Wortleitungen und Bitleitungen verlaufen.

Vorteilhafte Weiterbildungen der Erfindung ergeben sich aus den Unteransprüchen.

Die erfindungsgemäße Speicherzellenanordnung verwendet also eine vom bisherigen Stand der Technik mit 1/2-Teilung abweichende Architektur: die einzelnen Bitleitungspaare sind nicht mehr nebeneinander angeordnet, sondern jeweils durch eine Bitleitung eines anderen Paares getrennt, wodurch sich 1/4-Teilung ergibt. Damit ist es möglich, die zur Einstellung der Einsatzspannung benötigte Implantation mittels einer Implantationsmaske zu realisieren, die als durchgehender Streifen gestaltet werden kann und keine Eck- bzw. Verbindungsstellen aufweist.

Bei der erfindungsgemäßen Speicheranordnung können für die Speicherkondensatoren beispielsweise ferroelektrische Speicherkondensatoren verwendet werden. Die Erfindung kann aber in vorteilhafter Weise auch bei anderen Speichern, beispielsweise "Flash-Speichern", die eine hybride Struktur benötigen, angewandt werden.

Nachfolgend wird die Erfindung anhand der Zeichnungen näher erläutert. Es zeigen:
- Fig. 1: ein Speicherzellenfeld der erfindungsgemäßen Speicherzellenanordnung,
- Fig. 2: ein Layout zur Herstellung des Speicherzellenfeldes von Fig. 1,
- Fig. 3: die beim Layout von Fig. 2 verwendete Implantationsmaske,
- Fig. 4: ein Speicherzellenfeld einer herkömmlichen Speicherzellenanordnung,
- Fig. 5: ein Layout zum Herstellen des Speicherzellenfeldes von Fig. 4 und
- Fig. 6: die Implantationsmaske bei dem Layout von Fig. 5.

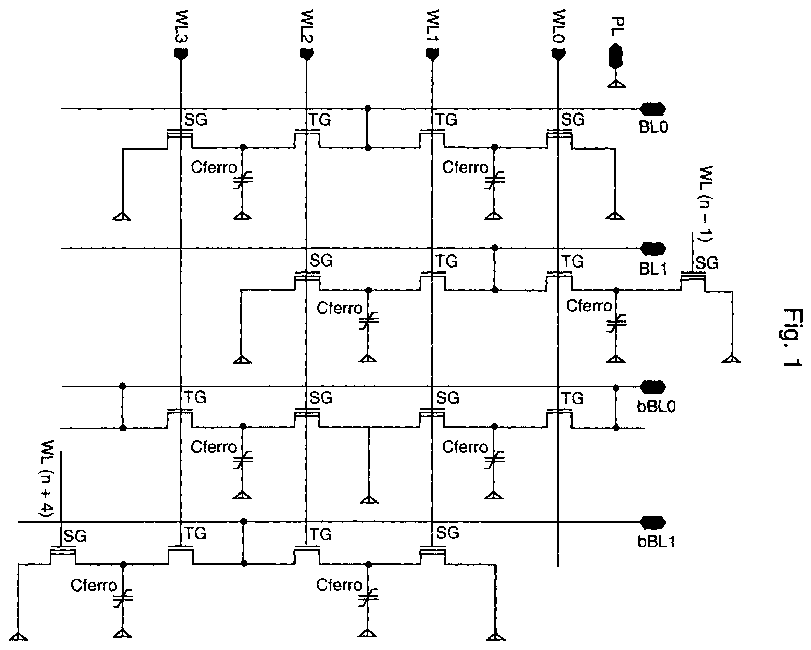

Die Fig. 4 bis 6 sind bereits eingangs erläutert worden. In den Fig. 1 bis 3 werden einander entsprechende Bauteile mit den gleichen Bezugszeichen wie in den Fig. 4 bis 6 versehen und nicht nochmals gesondert erläutert.

Fig. 1 zeigt nun ein Speicherzellenfeld, bei dem die Bitleitungen BL0 und bBL0 bzw. BL1 und bBL1 nicht nebeneinander paarweise verlaufen. Vielmehr folgt hier auf die Bitleitung BL0 die Bitleitung BL1, woran sich sodann die Bitleitungen bBL0 und bBL1 anschließen. Das heißt, die einzelnen Bitleitungspaare sind durch jeweils eine Bitleitung eines anderen Bitleitungspaares getrennt, wodurch sich für die Speicherzellen zueinander eine 1/4-Teilung ergibt.

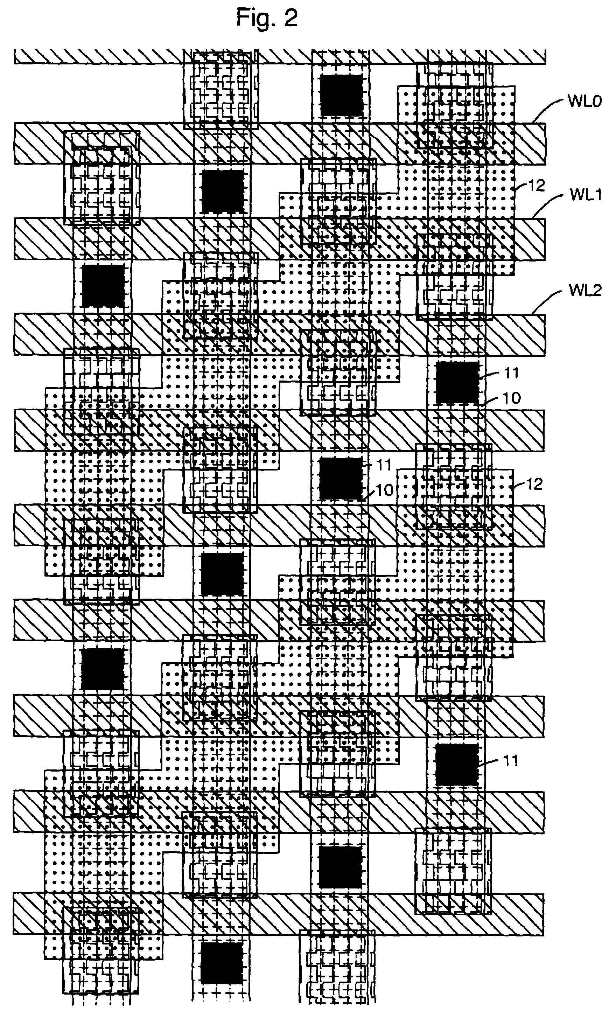

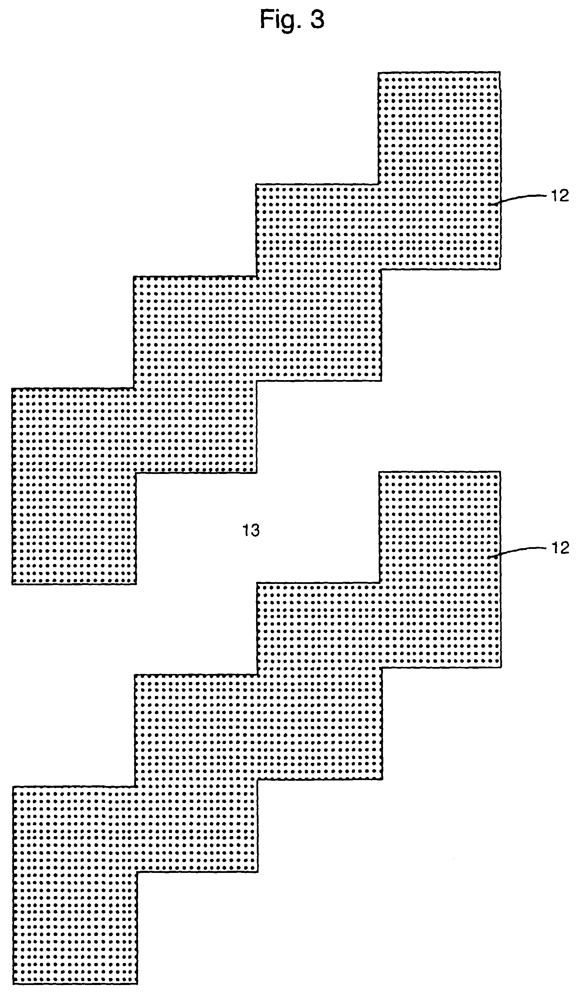

Diese andere Teilung hat nun erhebliche Auswirkungen auf die Gestaltung der Implantationsmaske 12, wie dies aus der Fig. 2 zu ersehen ist: die Implantationsmaske 12 besteht aus einzelnen Teilen, die derart stufenförmig versetzt über nebeneinanderliegende Bitleitungen gelegt sind, daß jeder einzelne Implantationsmasken-Teil in sich zusammenhängend ist und die einzelnen Implantationsmasken-Teile parallel zueinander und im Abstand voneinander schräg zu den Wortleitungen und die Bitleitungen verlaufen. In Fig. 3 sind diese Implantationsmasken-Teile 12 bzw. die hierzu komplementären Chrommaskenteile 13 nochmals gesondert herausgestellt. Wie aus den Fig. 2 und 3 klar zu ersehen ist, treten bei der erfindungsgemäßen Speicherzellenanordnung keine Verbindungs- bzw. Eckbereiche der Implantationsmasken auf, so daß mit solchen Bereichen verknüpfte Probleme zuverlässig vermieden werden. Diese andere Gestaltungsmöglichkeit der Implantationsmasken 12 ist durch die 1/4-Teilung bedingt, welche wiederum dadurch erreicht wird, daß zwischen einzelne Bitleitungspaare jeweils eine Bitleitung eines anderen Paares gelegt wird.

## Patentansprüche

1. Implantationsmaske zum Herstellen einer Speicherzellenanordnung aus mit Wortleitungen (WL0, WL1, WL2, ...) und Bitleitungen (BL0, bBL0; BL1, bBL1, ...) in einer Matrix verbundenen hybriden Speicherzellen, die jeweils aus einem insbesondere ferroelektrischen Speicherkondensator (Cferro) und einem Auswahltransistor (TG) bestehen, wobei jeder Speicherzelle ein Kurzschlußtransistor (SG) mit einer von der Einsatzspannung des Auswahltransistors (TG) unterschiedlichen Einsatzspannung zugeordnet ist, und wobei die einzelnen Bitleitungspaare (BL0, bBL0; BL1, bBL1) durch jeweils eine Bitleitung (beispielsweise BL1) eines anderen Bitleitungspaares voneinander getrennt sind, so daß die Speicherzellen zueinander unter 1/4-Teilung angeordnet sind,
**dadurch gekennzeichnet,** daß einzelne Implantationsmasken-Teile (12) derart stufenförmig versetzt über nebeneinanderliegende Bitleitungen (BL0, bBL0, BL1, bBL1) gelegt sind, daß jeder einzelne Implantationsmasken-Teil (12) in sich zusammenhängend ist, und daß die einzelnen Implantationsmasken-Teile parallel zueinander und im Abstand voneinander schräg zu den Wortleitungen (WL0, WL1, WL2, ...) und den Bitleitungen (BL0, bBL0, BL1, bBL1, ...) verlaufen.

2. Implantationsmaske nach Anspruch 1,
**dadurch gekennzeichnet,** daß die Maske selbst aus Chrom besteht.
